# EUROPEAN PATENT SPECIFICATION

(11) **EP 0 349 210 B1**
(45) Date of publication and mention of the grant of the patent: **17.03.1993**
(21) Application number: 89306373.5
(22) Date of filing: 23.06.1989
(51) Int. Cl.: H05K 5/02, G06K 13/08

(54) **Electronic apparatus with a memory card storage device**
Elektronisches Gerät mit einem Speicherungsmittel auf der Speicherkarte
Appareil électronique avec dispositif de stockage sur carte à mémoire

(30) Priority: 01.07.1988 JP 162475/88
(43) Date of publication of application: 03.01.1990
(73) Proprietor: Kabushiki Kaisha TOPCON, Tokyo (JP)
(72) Inventor: Wakatsuki, Hiroshi, Itabashi-ku Tokyo-to (JP)
(74) Representative: Jennings, Nigel Robin

(56) References cited:
- DE-A- 3 313 802
- PATENT ABSTRACTS OF JAPAN vol. 9, no. 243 (P-392)(1966) 30 September 1985 & JP-A-60 95782 (NIPPON DENSHIN DENWA KOSHA) 29 May 1985,

## Description

The present invention relates to electronic apparatus including a memory card storage device such as data collectors attached to electronic field or outdoor survey apparatus for use in surveying or measuring distances or gradients as are used in the civil engineering, architectural and constructional fields. The invention is concerned with that type of electronic apparatus which includes a main casing and a memory card storage device for receiving a memory card.

Nowadays, much of the survey apparatus used in the civil engineering and architectural fields is of electronic type so as to increase the precision of the measurements and to save time. Such electronic survey apparatus includes a data collector in order to reduce the time required for data processing and the entire surveying operation.

The data collector is typically adapted to process the input information in a predetermined manner and store the result in the data collector and to display guidance messages to facilitate the input of information.

It is necessary to have a large memory for storing the various programs which are required. However, it is also necessary that the data collector is small and readily portable and it is thus difficult to accommodate the various programs. If the collector is provided with a sufficient storage space for these programs, it becomes unacceptably expensive.

It has therefore been proposed that a memory card be used as an external memory and that various programs be memorised in the memory card. Portable electronic calculators and translators have adopted memory cards which are used after having been partly inserted into the portable electronic device.

Portable calculators are generally used inside a building so that no special countermeasures are required to dustproof or waterproof the mechanism in which the memory card is inserted and stored. Thus, even if a part of the card is exposed, i.e. extends out of the body of the calculator no problems arise.

However, if the apparatus is of the type which may be used outside, e.g. a data collector, strong winds, rain and dust must be contended with and in order to ensure reliability of the apparatus some form of dustproofing is desirable.

Furthermore, if a part of the memory card is exposed it is potentially subject to accidental damage.

DE-A-3313802 discloses electrical apparatus employing a removable memory cassette housed in a closable recess in the casing of the apparatus.

Patent Abstracts of Japan, vol.9, No.243 (p.392) (1966) 30 September 1985 discloses electrical apparatus including a hinged cover which receives a memory card, including means for biassing the card into good electrical contact.

It is the object of the present invention to provide an electronic apparatus which includes a memory card storage device in which the memory card is inherently protected from dust, rain and from accidental damage but can nevertheless be readily inserted in the apparatus and removed again.

According to the present invention there is provided an electronic apparatus including a main casing and a memory card storage device for receiving a memory card, wherein the main casing includes a lid which is pivotally connected thereto and defines a space which accommodates a slidable card connector and, in use, a memory card connected to the card connector, that one or more pivotal links are provided which are pivotally connected to the main casing and that the card connector is connected to at least one slide link, the or each slide link being connected to an associated pivotal link by a pin which extends through an opening in the slide link and an elongate opening in a portion of the lid, whereby, in use, the action of opening the lid causes the pivotal link(s) to pivot with respect to the main casing and thereby causes the card connector and a memory card connected thereto to slide in the space in the lid. Thus, in use, the memory card is accommodated within the main casing and the lid is kept closed thereby protecting it from damage and dust. However, when the lid is open the pivotal links rotate and due to the connection with the card connector the latter and thus also the memory card are moved forwardly so as to expose it for easy removal.

Preferred features of the construction are that the lid is pivotally connected at one end to the main casing and that the pivotal link is an elongate member pivotally connected at one end to the main casing in the region of a portion of the casing which cooperates with the free end of the lid when the lid is closed.

The elongate opening in the lid preferably forms part of an L-shaped opening of which a portion extends transverse to the elongate portion and the opening in the slide link is preferably elongate and corresponds to the transverse portion. The provision of one or more L-shaped openings results in the lid inherently being locked when in the open position and the provision of the elongate opening in the slide link permits the pin to move in the transverse portion of the L-shaped opening without resulting in simultaneous movement of the slide link.

It is preferred that the apparatus includes a spring which acts on the lid in the opening direction and locking means arranged to lock the lid in the closed position. The locking means may take various forms but in one embodiment a locking plate is provided which is slidably attached to the main casing to move between a locked position and an unlocked position, the locking plate and the lid having cooperating means which engage to prevent opening of the lid when the locking plate is in the locked position and which permit opening of the lid when the locking plate is in the unlocked position. The cooperating means may also take various forms but preferably comprise one or more projections on the locking plate which engage in one or more notches or undercuts formed in a portion of the lid when the latter is in the closed position.

The apparatus preferably includes a locking knob carried by the main casing which is operative to move the locking plate between the locked and unlocked positions. The locking knob is preferably rotatably connected to the main casing and carries an eccentric pin which is received in a slot in the locking plate whereby rotation of the locking knob results in linear movement of the locking plate.

Whilst the accommodation of the memory card in a space which is closed by the lid protects the memory card from accidental mechanical damage and, in most cases, from damage by dust or the like, the latter protection may be increased by the provision of a sealing strip which extends around the opening in the main casing and forms a seal with the lid when it is closed.

Further features and details of the invention will be apparent from the following description of two specific embodiments which is given by way of example with reference to the accompanying drawings, in which:
Figure 1 is a perspective view from above of one embodiment of data collector incorporating a memory card storage device in accordance with the present invention;
Figure 2 is a perspective view from below of the data collector showing the memory card storage device pivoted outwardly;
Figure 3 is a cross-sectional view in the direction of the arrows A-A in Figure 1;
Figure 4 is a sectional view on the line B-B in Figure 3;
Figure 5 is a sectional view on the line C-C in Figure 4;
Figure 6 is a view similar to Figure 5 showing the lid of the data collector open;
Figure 7 is a sectional view taken on the line D-D in Figure 4 with the lid closed;
Figure 8 shows the data collector with the lid open;
Figure 9 is a perspective view showing the relationship of the lid to the locking plate; and
Figure 10 is a view similar to Figure 8 of a modified construction of memory card storage device.

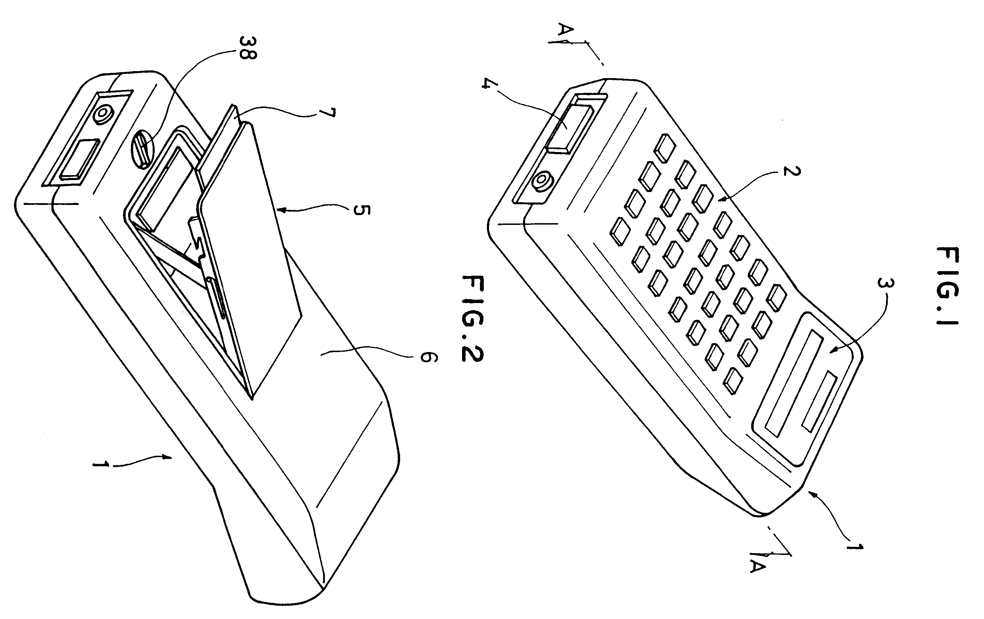

Figure 1 shows a data collector 1 including an input portion 2, a display portion 3 and a connector 4 used to connect the data collector 1 to another information processing device (not shown).

Provided at the rear 6 of the data collector 1 is a memory card storage device 5 in accordance with the present invention, as shown in Figure 2.

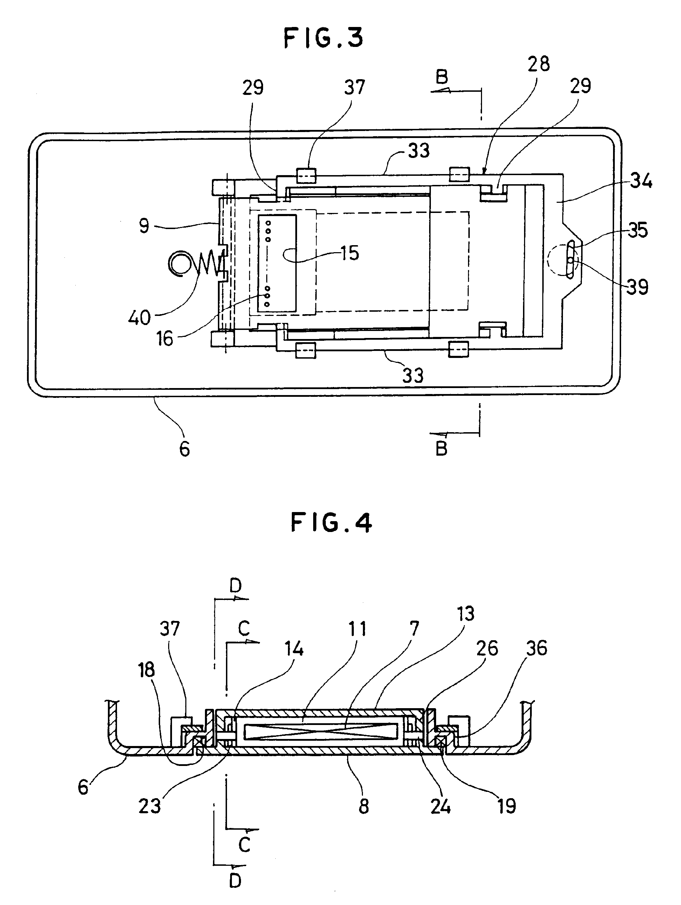

The structure of the storage device 5 will be described with reference to Figures 3 to 9.

The storage device includes a lid 8 functioning both as part of the rear wall 6 and as a holder for a memory card 7. The lid 8 is rotatably joined to the rear wall 6 by means of a hinge 9 of a channel shape. The lid 8 has a peripheral edge 10 adapted to contact a seal, which will be described below and a case portion 13 within the outer profile of the data collector and containing or receiving the memory card 7. The lid 8 also has a card connector 11 at about its centre. The card connector 11 is slidably fitted to the case portion 13 by a pair of slide links 14 which are attached on both sides of the card connector 11.

The case portion 13 has a rectangular window 15 formed near its hinge side. Extending from the card connector 11 towards the interior of the data collector is a set of connector pins 16. The window 15 prevents the connector pins 16 from interferring with or contacting the case portion 13 when the card connector 11 slides.

The rear wall 6 has an opening 17 which receives the lid 8 and has a seal groove 18 extending around its periphery. A seal 19 is provided in the seal groove 18 and is firmly contacted by the peripheral edge 10 of the lid. A bag portion 20, that is to say a web integral with the rear wall 6, is provided within the opening 17 at the end opposite to the hinged end which extends parallel and adjacent to the lid when it is closed. A pair of shaft supporters or lugs 21 extend from the outer face of the bag portion 20. One or more elongate pivotal links 23 are pivotally connected at one end to each lug 21 by a respective pin 22 and carry a laterally projecting slide pin 24 at their other end. The slide pins 24 engage in oval openings 25 in the slide links 14. The long axis of the oval openings is directed at right angles to the sliding direction of the slide links 14. The slide pins 24 have portions extending through the oval openings 25 and these portions slidably engage in L-shaped openings 27 which comprise a longitudinal portion and a short upwardly extending portion 43 and are formed in a pair of side walls 26 of the case portion 13. Each side wall 26 has a front and rear notch 30 which are adapted to engage with engagement portions 29 of a locking plate 28. Each notch 30 consists of an entry portion 31 through which the associated engagement portion 29 can enter and an undercut portion 32 with a tapered edge with which the engagement portion 29 engages.

The locking plate 28 is U-shaped and embraces the edge of the opening 17, as shown in Figure 3. The engagement portions 29 are formed on the inside of the two limbs 33 of the locking plate 28 and extend inwardly. The upper edge of the engagement portions 29 is chamfered so as to smoothly engage the associated notch 30. The base 34 connecting the limbs 33 has a slit 35 extending longitudinally of the cross-portion 34. The locking plate 28 is placed on a stepped portion or shoulder 36 in which the seal groove 18 is formed and held slidably by locking plate clips 37.

A locking knob 38 is rotatably secured to the rear wall 6 at the end opposite part to the hinge of the storage device 5. An eccentric pin 39 on the locking knob 38 extends into the slit 35.

As shown in Figure 3, a compression spring 40 acts on the lid 8 in the direction of its length and tends to open it. Connected to the body of the data collector 1 is a connector 41.

A pad or cushion 42 secured to the inner surface of the web 20 restrains rattling or vibration of the memory card 7 when it is inserted into the storage device.

The operation of the data collector 1 with the memory card storage device 5 is as follows:
Figures 3,4,5 and 7 show the data collector 1 with the card storage device 5 and the memory card 7 stored in it. In the stored condition, the engagement portions 29 of the locking plate 28 engage in the portions 32 of the notches 30 and the lid 8 is locked in its closed position.

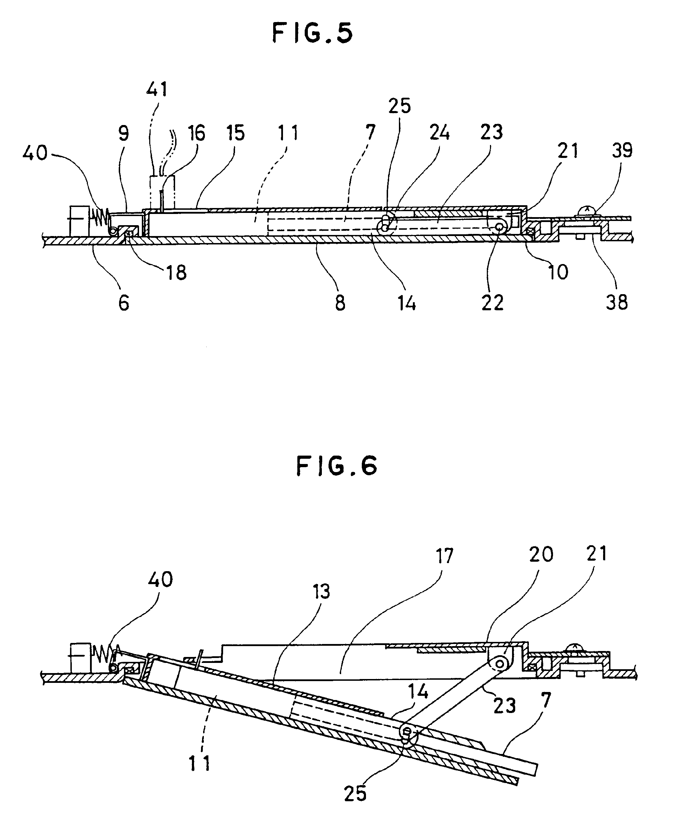

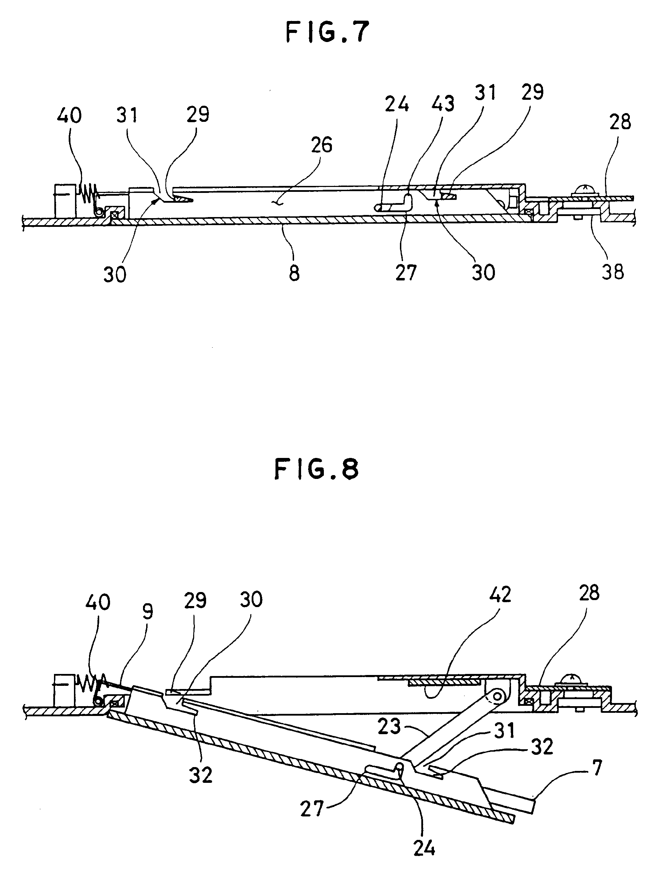

In order to remove the memory card 7, the locking knob 38 is rotated through 180°. Due to the eccentric position of the pin 39 it moves towards the hinge side of the card connector 11 by a distance which is twice the eccentricity. This movement of the pin 39 makes the locking plate 28 slide towards the hinge. When the locking plate 28 slides and the engagement portions 29 move into registry with the entrance portions 31 of the notches 30, the lid 8 is unlocked and the lid 8 opens a little under the action of the compression spring 40. When a manual force is applied to the lid 8 in order to open it further, the lid 8 rotates clockwise, as shown in Figures 6 and 8, the pivotal links 23 rotate anti-clockwise, the slide pins 24 move in the L-shaped openings 27 towards the end of the lid 8 and the slide links 14, connected to the pivotal links 23 by means of the slide pins 24, slide toward the open end of the lid 8 together with the card connector 11. When the slide pins 24 reach the end of their travel, they enter the vertical portions 43 of the L-shaped openings 27. This change in direction of the movement of the slide pins 24 is permitted by the oval openings 25 in the slide links 14. This position is the final open position of the lid 8, in which the sliding movement of the card connector 11 causes the front edge of the memory card 7 to extend a little beyond the front end of the lid 8.

The user can then easily remove the memory card 7 from the data collector 1. When the slide pins 24 engage in the vertical portions 43 of the L-shaped openings 27, as described above, and the lid 8 is open as shown in Figure 8, sliding movement of the slide pins 24 is restrained. As a result, the lid 8 is locked firmly in position during insertion or removal of the memory card 7.

When the card connector 11 is to be retracted, the lid 8 is closed after disengaging the slide pins 24 from the portions 43 and thereafter sliding them back along the openings 27. The lid 8 is finally closed by applying a light manual force to it and rotating the locking knob 38.

Due to the resultant movement of the eccentric pin 39, as described above, the locking plate 28 is moved towards the front end of the lid 8 and the engagement portions 29 engage in the undercuts 32 thereby locking the lid 8.

The locking process is facilitated by engagement of the chamfered engagement portions 29 and the tapered faces of the undercuts 32. In addition, the wedging effect of the wedge-shaped engagement portions 29 in the undercuts 32 deforms the seal 19 enabling the lid 8 to lock firmly and produce an effective seal.

In the embodiment described above, the lid 8 is locked by means of an eccentric pin and cooperating locking plate. However, a knurled screw may be used to obtain the same effect. Also the compression spring for urging the lid 8 in the opening direction may be replaced by e.g. a torsion spring adapted to rotate the pivotal links anti-clockwise.

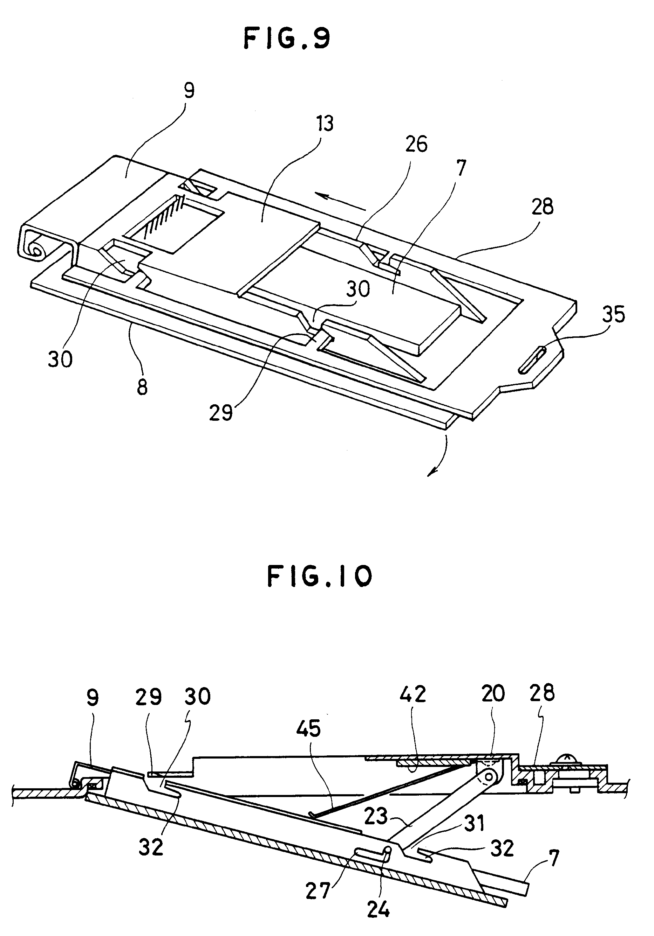

Alternatively, as shown in Figure 10, a leaf spring 45 may be secured to the outer face of the web 20 to apply an opening force to the lid 8. If the slide links 14 are pivotally connected to the card connector 11 and the pivotal links 23, then the portions 43 of the openings 27 may be omitted.

Although only two embodiments of the invention have been described, it will be apparent that other embodiments and modifications of the invention are possible. The present invention can of course be applied to electric and electronic devices other than the data collector described above.

## Claims

1. Electronic apparatus including a main casing and a memory card storage device for receiving a memory card, wherein the main casing (1) includes a lid (8) which is pivotally connected thereto and defines a space which accommodates a slidable card connector (11) and, in use, the memory card (7) connected to the card connector (11), that one or more pivotal links (23) are provided which are pivotally connected to the main casing (1) and that the card connector (11) is connected to at least one slide link (14), the or each slide link (14) being connected to an associated pivotal link (23) by a pin (24) which extends through an opening (25) in the slide link (14) and an elongate opening (27) in a portion (26) of the lid (8), whereby, in use, the action of opening the lid (8) causes the pivotal link(s) (23) to pivot with respect to the main casing (1) and thereby causes the card connector (11) and a memory card connected thereto to slide in the space in the lid (8).

2. Apparatus as claimed in claim 1 characterised in that the lid (8) is pivotally connected at one end to the main casing and that the pivotal link (23) is an elongate member pivotally connected at one end to the main casing in the region of a portion of the casing (1) which cooperates with the free end of the lid (8) when the lid is closed.

3. Apparatus as claimed in claim 1 or claim 2, characterised in that the elongate opening forms part of an L-shaped opening (27) of which a portion (43) extends transverse to the elongate portion and that the opening (25) in the slide link (14) is elongate and corresponds to the portion (43).

4. Apparatus as claimed in any one of the preceding claims, characterised by a spring (40) which acts on the lid (8) in the opening direction and locking means (28,29,32) for locking the lid (8) in the closed position.

5. Apparatus as claimed in claim 4, characterised in that the locking means comprises a locking plate (28) which is movably attached to the main casing (1), the locking plate (28) and the lid (8) having cooperating means (29,32) which engage to prevent opening of the lid (8) when the locking plate (28) is in a locked position and which permit opening of the lid when the locking plate is in an unlocked position.

6. Apparatus as claimed in claim 5, characterised in that the cooperating means (29,32) comprise one or more projections (29) on the locking plate and one or more notches or undercuts (32) formed in a portion (26) of the lid (8).

7. Apparatus as claimed in claim 6, characterised by a locking knob (38) carried by the main casing (1) which is operative to move the locking plate (28) between the locked and unlocked positions.

8. Apparatus as claimed in claim 7, characterised in that the locking knob (38) is rotatably connected to the main casing (1) and carries an eccentric pin (39) which is received in a slot (35) in the locking plate (28).

9. Apparatus as claimed in any one of the preceding claims, characterised by a sealing strip (18) which extends around the opening (17) in the main casing (1) and forms a seal with the lid (8) when it is closed.

## Patentansprüche

1. Elektronische Vorrichtung, die ein Hauptgehäuse und eine Speicherkarten-Aufnahmeeinrichtung zur Aufnahme einer Speicherkarte enthält, bei der
das Hauptgehäuse (1) einen Deckel (8) enthält, der mit diesem schwenkbar verbunden ist und einen Raum bestimmt, der einen gleitbaren Kartenverbinder (11) und bei Gebrauch die mit dem Kartenverbinder (11) verbundene Speicherkarte (7) aufnimmt,
eines oder mehrere schwenkbare(s) Verbindungsglied(er) (23) vorgesehen sind, die mit dem Hauptgehäuse (1) schwenkbar verbunden sind, und
der Kartenverbinder (11) mit mindestens einem gleitbaren Verbindungsglied (14) verbunden ist, wobei dieses eine oder jedes gleitbare Verbindungsglied (14) mit einem zugehörigen schwenkbaren Verbindungsglied (23) durch einen Stift (24) verbunden ist, der sich durch eine Öffnung (25) in dem gleitbaren Verbindungsglied (14) und eine längliche Öffnung (27) in einem Bereich (26) des Deckels (8) erstreckt, wobei bei Gebrauch der Öffnungsvorgang des Deckels (8) das oder die schwenkbare(n) Verbindungsglied(er) (23) veranlaßt, sich in bezug auf das Hauptgehäuse (1) zu verschwenken, und dabei den Kartenverbinder (11) und eine mit diesem verbundene Speicherkarte veranlaßt, in den Raum in dem Deckel (8) zu gleiten.

2. Vorrichtung gemäß Anspruch 1, **dadurch gekennzeichnet,** daß der Deckel (8) an einem Ende schwenkbar mit dem Hauptgehäuse verbunden ist und daß das schwenkbare Verbindungsglied (23) durch ein Längselement gebildet wird, das an einem Ende schwenkbar mit dem Hauptgehäuse in dem Bereich eines Abschnittes des Gehäuses (1) verbunden ist, der mit dem freien Ende des Deckels (8) zusammenwirkt, wenn der Deckel geschlossen ist.

3. Vorrichtung gemäß einem der Ansprüche 1 oder 2, **dadurch gekennzeichnet,** daß die längliche Öffnung einen Teil einer L-förmigen Öffnung (27) bildet, von der ein Bereich (43) sich längs zu dem länglichen Abschnitt erstreckt und daß die Öffnung (25) in dem gleitbaren Verbindungsglied (14) länglich ist und dem Bereich (43) entspricht.

4. Vorrichtung gemäß einem der vorhergehenden Ansprüche, **gekennzeichnet durch** eine Feder (40), die auf dem Deckel (8) in der Öffnungsrichtung und auf die Verriegelungsmittel (28, 29, 32) zur Verriegelung des Deckels (8) in der verschlossenen Position wirkt.

5. Vorrichtung gemäß Anspruch 4, **dadurch gekennzeichnet** daß die Verriegelungsmittel eine Verriegelungsplatte (28) umfassen, die beweglich an dem Hauptgehäuse (1) angebracht ist, wobei die Verriegelungsplatte (28) und der Deckel (8) zusammenwirkende Mittel (29, 32) aufweisen, die in Eingriff stehen, um die Öffnung des Deckels (8) zu verhindern, wenn die Verriegelungsplatte (28) sich in einer verriegelten Position befindet, und die die Öffnung des Deckels erlauben, wenn die Verriegelungsplatte sich in einer unverriegelten Position befindet.

6. Vorrichtung gemäß Anspruch 5, **dadurch gekennzeichnet** daß die zusammenwirkenden Mittel (29, 32) einen oder mehrere Vorsprünge (29) auf der Verriegelungsplatte und eine oder mehrere Kerben oder Hinterschneidungen (32) umfassen, die in einem Bereich (26) des Deckels (8) ausgebildet sind.

7. Vorrichtung gemäß Anspruch 6, **gekennzeichnet durch** einen durch das Hauptgehäuse (1) getragenen Verriegelungsknopf (38), der betätigbar ist, um die Verriegelungsplatte (28) zwischen der verriegelten und der entriegelten Position zu bewegen.

8. Vorrichtung gemäß Anspruch 7, **dadurch gekennzeichnet,** daß der Verriegelungsknopf (38) schwenkbar mit dem Hauptgehäuse (1) verbunden ist und einen exzentrischen Stift (39) trägt, der von einem Schlitz (35) in der Verriegelungsplatte (28) aufgenommen wird.

9. Vorrichtung gemäß einem der vorhergehenden Ansprüche, **gekennzeichnet durch** einen Dichtungsstreifen (18) der sich um die Öffnung (17) in dem Hauptgehäuse (1) erstreckt und eine Dichtung mit dem Deckel (8) bildet, wenn dieser verschlossen ist.

## Revendications

1. Appareil électronique comprenant un boîtier principal et un dispositif de stockage sur carte mémoire destiné à recevoir une carte mémoire, dans lequel le boîtier principal (1) comprend un couvercle (8) qui y est articulé et qui délimite un espace destiné à recevoir un connecteur de carte coulissant (11) et, en service, la carte mémoire (7) connectée au connecteur de carte (11), une ou plusieurs biellettes pivotantes (23) sont prévues et articulées au boîtier principal (1) et le connecteur de carte (11) est relié à au moins une biellette coulissante (14), la ou les biellettes coulissantes (14) étant chacune reliées à une biellette pivotante (23) associée par un pivot (24) qui traverse une ouverture (25) dans la biellette coulissante (14) et une ouverture oblongue (27) dans une partie (26) du couvercle (8), de sorte qu'en service, le fait d'ouvrir le couvercle (8) fait pivoter la ou les biellettes pivotantes (23) par rapport au boîtier principal (1) et force ainsi le connecteur de carte (11) et une carte mémoire qui y est connectée à coulisser dans l'espace prévu dans le couvercle (8).

2. Appareil suivant la revendication 1, caractérisé en ce que le couvercle (8) est articulé à une extrémité au boîtier principal et que la biellette pivotante (23) est un long élément articulé à une extrémité au boîtier principal dans la région d'une partie de ce boîtier (1) qui coopère avec l'extrémité libre du couvercle (8) lorsque ce couvercle est fermé.

3. Appareil suivant la revendication 1 ou 2, caractérisé en ce que l'ouverture oblongue fait partie d'une ouverture en forme de L (27) dont une partie (43) s'étend transversalement à la partie oblongue, et l'ouverture (25) dans la biellette coulissante (14) est oblongue et correspond à la partie (43).

4. Appareil suivant l'une quelconque des revendications précédentes, caractérisé par un ressort (40) qui agit sur le couvercle (8) dans le sens de l'ouverture et un moyen de verrouillage (28, 29, 32) pour verrouiller le couvercle (8) dans la position de fermeture.

5. Appareil suivant la revendication 4, caractérisé en ce que le moyen de verrouillage comprend une plaque de verrouillage (28) qui est attachée de façon mobile au boîtier principal (1), la plaque de verrouillage (28) et le couvercle (8) comportant des moyens coopérants (29, 32) qui viennent en prise pour empêcher toute ouverture du couvercle (8) lorsque la plaque de verrouillage (28) se trouve dans une position verrouillée et qui permettent l'ouverture du couvercle lorsque la plaque de verrouillage se trouve dans une position déverrouillée.

6. Appareil suivant la revendication 5, caractérisé en ce que les moyens coopérants (29, 32) comprennent une ou plusieurs saillies (29) sur la plaque de verrouillage et une ou plusieurs encoches à affouillement (32) ménagées dans une partie (26) du couvercle (8).

7. Appareil suivant la revendication 6, caractérisé par un bouton de verrouillage (38) porté par le boîtier principal (1), qui peut être actionné pour déplacer la plaque de verrouillage (28) entre ses positions verrouillée et déverrouillée.

8. Appareil suivant la revendication 7, caractérisé en ce que le bouton de verrouillage (38) est monté à rotation sur le boîtier principal (1) et porte un ergot excentrique (39) qui est reçu dans une boutonnière (35) dans la plaque de verrouillage (28).

9. Appareil suivant l'une quelconque des revendications précédentes, caractérisé par une bande d'étanchéité (18) qui s'étend autour de l'ouverture (17) dans le boîtier principal (1) et forme un joint d'étanchéité avec le couvercle (8), lorsque celui-ci est fermé.
